(19) Europäisches Patentamt
European Patent Office
Office européen des brevets

(11) **EP 3 187 561 B1**

(12) **EUROPEAN PATENT SPECIFICATION**

(45) Date of publication and mention
of the grant of the patent:
**09.10.2019 Bulletin 2019/41**

(51) Int Cl.:
***H01L 23/29*** *(2006.01)*     ***H01L 21/56*** *(2006.01)*
***H01L 23/31*** *(2006.01)*

(21) Application number: **15836357.2**

(86) International application number:
**PCT/JP2015/072379**

(22) Date of filing: **06.08.2015**

(87) International publication number:
**WO 2016/031521 (03.03.2016 Gazette 2016/09)**

(54) **SEALING SHEET WITH A SEPARATOR AND PRODUCTION METHOD FOR SEMICONDUCTOR DEVICE**

DICHTUNGSBAHN MIT TRENNELEMENT SOWIE HERSTELLUNGSVERFAHREN FÜR HALBLEITERBAUELEMENT

FEUILLE D'ÉTANCHÉITÉ AVEC SÉPARATEUR ET PROCÉDÉ DE PRODUCTION D'UN DISPOSITIF À SEMI-CONDUCTEURS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.08.2014 JP 2014175772**

(43) Date of publication of application:
**05.07.2017 Bulletin 2017/27**

(73) Proprietor: **Nitto Denko Corporation**
**Ibaraki-shi, Osaka 567-8680 (JP)**

(72) Inventors:
• **IINO, Chie**
**Ibaraki-shi**
**Osaka 567-8680 (JP)**

• **SHIGA, Goji**
**Ibaraki-shi**
**Osaka 567-8680 (JP)**
• **ISHII, Jun**
**Ibaraki-shi**
**Osaka 567-8680 (JP)**

(74) Representative: **Grünecker Patent- und Rechtsanwälte PartG mbB Leopoldstraße 4 80802 München (DE)**

(56) References cited:
| JP-A- 2008 311 348 | JP-A- 2014 131 016 |
| JP-A- 2014 131 016 | US-A1- 2007 254 986 |
| US-A1- 2012 295 416 | US-A1- 2013 078 770 |

**Description**

TECHNICAL FIELD

The present invention relates toa sealing sheet with a separator, and a production method for a semiconductor device.

BACKGROUND ART

Hitherto, a production method for a semiconductor device has been known in which a sealing sheet is arranged onto one or more semiconductor chips fixed to, e.g., a substrate, and subsequently the workpiece is pressurized while heated, so as to bury the semiconductor chip(s) into the sealing sheet (see, for example, Patent Document 1).
Patent Document 2 discloses an epoxy resin molding material for sealing, comprising an epoxy resin, an epoxy resin curing agent, and a pitch.
Patent Document 3 discloses a sealing sheet having a tensile storage modulus at 60°C before the sheet is thermally cured of 0.01 to 1000 MPa. The constituent material of the sealing sheet contains epoxy and/or phenolic resin.

PRIOR ART DOCUMENT

PATENT DOCUMENT

   Patent Document 1: JP-A-2006-19714
   Patent Document 2: US-A-2007/254986
   Patent Document 3: US-A-2012/295416

SUMMARY OF THE INVENTION

PROBLEMS TO BE SOLVED BY THE INVENTION

When used, a sealing sheet as described above may be held up by an adsorbing collet, and then carried. However, at the time of, e.g. , the holding up or the carrying, the sealing sheet may unfavorably drop down from the adsorbing collet. If the sealing sheet is too hard, there may arise a problem that semiconductor chips cannot be suitably buried into the sheet.
In light of the problems, the present invention has been made. An object thereof is to provide a sealing sheet, and a sealing sheet with a separator, these sheets being each a sheet which can be prevented from dropping down from an adsorbing collet when the collet-held sheet is, for example, carried, and further which one or more semiconductor chips can be suitably buried into. Another object thereof is to provide a semiconductor device produced using any one of the sealing sheet and the sealing sheet with the separator. Still another object thereof is to provide a production method for a semiconductor device using the sealing sheet with the separator.

MEANS FOR SOLVING THE PROBLEMS

The inventors have made eager researches about the above-mentioned problems. As a result, the inventors have found out that when the product of the thickness of a sealing sheet and the storage modulus G' thereof is in a predetermined range, the sealing sheet can drop down from an adsorbing collet when the collet-held sheet is, for example, carried, and that one or more semiconductor chips can be suitably buried into the sealing sheet. Thus, the present invention has been accomplished.
Accordingly, the present invention provides a sealing sheet with a separator according to appended claim 1.
Firstly, about the thickness of a sealing sheet, the sheet bends, or warps more easily as the thickness is smaller. In the meantime, the sheet bends less easily as the thickness is larger. Secondly, about the storage modulus of a sealing sheet, the sheet is softer to bend more easily as the value of this modulus is smaller. In the meantime, the sheet is harder to bend less easily as the value is larger. Accordingly, when the thickness of a sealing sheet is small, the sheet unfavorably bends unless the storage modulus thereof is made large to some degree. In the meantime, when the thickness of the sealing sheet is large, the sheet does not bend even when the storage modulus thereof is not very large. The inventors have found out that as described just above, the thickness and the storage modulus of a sealing sheet are closely related to the bend thereof. The inventors have found out that by setting the product $\alpha$ of the thickness and the storage modulus to 300 or more, the sealing sheet can be prevented from bending to drop down when the sheet is, for example, carried.

If the storage modulus is too high, one or more semiconductor chips cannot be buried into the sealing sheet although the bending can be restrained. Thus, usually, considering the thickness of a sheet used as a sealing sheet, one or more semiconductor chips can be buried suitably into the sealing sheet by setting the product $\alpha$ of the thickness and the storage modulus to $1.5 \times 10^5$ or less. This fact has been found out by the inventors.

From the above, according to the sealing sheet of the present invention, the product $\alpha$ of the thickness t [mm] and the storage modulus G' [Pa] at 50°C is in the range satisfying the above-mentioned expression 1, so that the sealing sheet can drop down from an adsorbing collet when the collet-held sheet is, for example, carried, and further one or more semiconductor chips can be suitably buried into the sealing sheet.

About the temperature at which the storage modulus G' is measured, the reason why the temperature is set not to a temperature at which the collet-held sheet is carried, i.e., room temperature (25°C) but to 50°C is as follows: the temperature 25°C makes an accidental error in the measurement large; thus, a temperature is adopted which makes the accidental error small, and which is further close to room temperature.

The sealing sheet with a separator according to the present invention
has a bend elastic constant E [N/mm²] at 25°C of 100 to 3000 N/mm²; the sealing sheet having an area A [mm²] of 40000 mm² or more; wherein the product $\beta$ of E in N/mm² and A in mm² satisfies the following expression 2:
expression 2: $4.0 \times 10^6 \le \beta \le 1.7 \times 10^9$.

About the area of a sealing sheet, the sheet bends more easily as the area is larger. The sheet bends less easily as the area is smaller. About the bend elastic constant of a sealing sheet, the sheet is softer to bend more easily as the value thereof is smaller. In the meantime, the sheet is harder to bend less easily as the value is larger. Accordingly, when the area of a sealing sheet is large, the sheet unfavorably bends unless the bend elastic constant thereof is made large to some degree. In the meantime, when the area of the sealing sheet is small, the sheet does not bend even when the bend elastic constant thereof is not very large. By setting the product $\beta$ of the thickness and the bend elastic constant to $4.0 \times 10^6$ or more, the sealing sheet can be prevented from bending to drop down when the sheet is, for example, carried. When the area is large, the bend elastic constant needs to be made large to some degree. However, if the bend elastic constant is high and exceeding an appropriate range of this constant, the sealing sheet comes to have a problem about chip-burying performance. Thus, by setting the range of $\beta$ to $1.7 \times 10^9$ or less, one or more semiconductor chips can be appropriately buried into the sealing sheet without deforming or bending the resin sheet.

A semiconductor device can be produced using the above-defined sealing sheet with the separator.

Since the sealing sheet with the separator satisfies the expression 1, the sealing sheet is restrained from dropping down from an adsorbing collet when the collet-held sheet is, for example, carried. Moreover, because of the use of this sealing sheet with the separator, one or more semiconductor chips are suitably buried in the sealing sheet. For this reason, thus produced semiconductor devices can be improved in yield.

In the above-mentioned structure, about the sealing sheet, the area A thereof is preferably 40000 mm² or more.

In the above-mentioned structure, about the sealing sheet with the separator, the area A of the sealing sheet is 40000 mm² or more.

This sealing sheet satisfies the expression 1 to be restrained from bending. Accordingly, even when the area A of the sealing sheet is rendered a large area of 40000 mm² or more, the sealing sheet can be restrained from dropping down from an adsorbing collet when the collet-held sheet is, for example, carried.

The production method for a semiconductor device according to the present invention, includes:

    step A of providing a stacked body including a support (60) and one or more semiconductor chips (53) fixed onto the support,
    step B of providing the above-defined sealing sheet with the separator (10),
    step C of arranging the sealing sheet with the separator over the semiconductor chip(s) of the stacked body, and
    step D of burying the semiconductor chip(s) into the sealing sheet to form a sealed body in which the semiconductor chip(s) is/are buried in the sealing sheet.

According to this aspect, the sealing sheet satisfies the expression 1; thus, the sealing sheet is restrained from dropping down from an adsorbing collet when the collet-held sheet is, for example, carried. Accordingly, semiconductor devices each produced using such a sealing sheet with a separator can be improved in yield.

EFFECTS OF THE INVENTION

The present invention makes it possible to provide a sealing sheet with a separator which can be prevented from dropping down from an adsorbing collet when the collet-held sheet is, for example, carried, and further which one or more semiconductor chips can be suitably buried into. The invention also makes it possible to provide a production method for a semiconductor device using the sealing sheet with the separator.

BRIEF DESCRIPTION OF THE DRAWINGS

Fig. 1 is a schematic cross section of a sealing sheet with separators on both surfaces according to the present invention.
Fig. 2 is a schematic cross section for explaining a method for manufacturing a semiconductor device according to the present invention.
Fig. 3 is a schematic cross section for explaining a method for manufacturing a semiconductor device according to the present invention.
Fig. 4 is a schematic cross section for explaining a method for manufacturing a semiconductor device according to the present invention.
Fig. 5 is a schematic cross section for explaining a method for manufacturing a semiconductor device according to the present invention.
Fig. 6 is a schematic cross section for explaining a method for manufacturing a semiconductor device according to the present invention.
Fig. 7 is a schematic cross section for explaining a method for manufacturing a semiconductor device according to the present invention.
Fig. 8 is a schematic cross section for explaining a method for manufacturing a semiconductor device according to the present invention.
Fig. 9 is a schematic cross section for explaining a method for manufacturing a semiconductor device according to the present invention.
Fig. 10 is a schematic cross section for explaining a method for manufacturing a semiconductor device according to the present invention.

MODE FOR CARRYING OUT THE INVENTION

Hereinafter, the present invention will be described with reference to the drawings.

(Sealing Sheet with Separator)

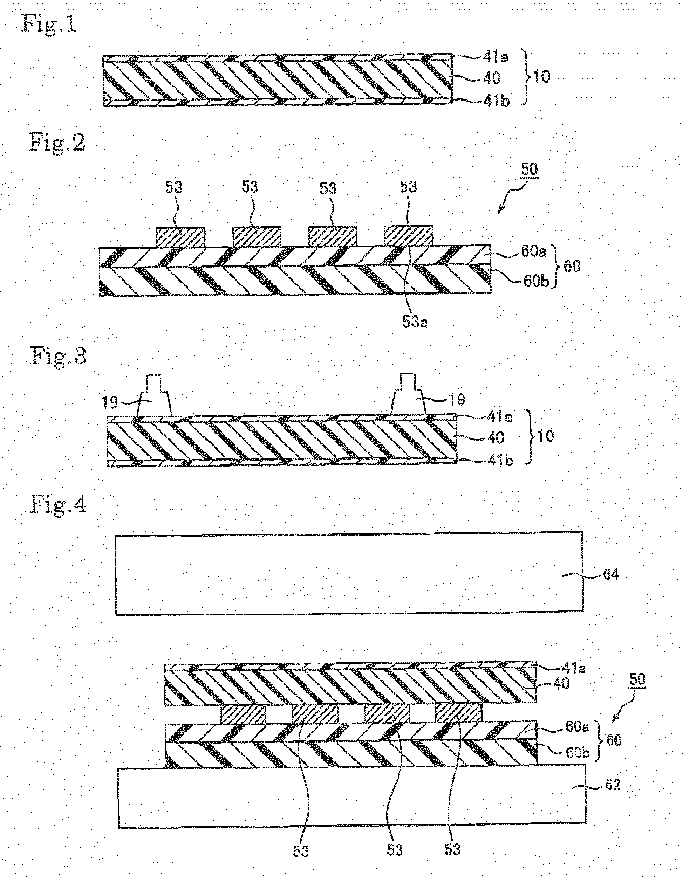

Fig. 1 is a schematic sectional view of a sealing sheet with a separator according to the present invention. As illustrated in Fig. 1, this separator-attached sealing sheet, which is a sheet 10, has a sealing sheet 40, a separator 41a stacked on one of the two surfaces of the sealing sheet 40, and a separator 41b stacked on the other surface of the sealing sheet 40. The separator 41a and the separator 41b each correspond to the separator in the present invention.
In the present embodiment, a description will be made about a case where the separator-attached sealing sheet of the present invention is a double-sided separator-attached sealing sheet in which separators are stacked, respectively, onto both surfaces of a sealing sheet. However, the separator-attached sealing sheet of the present invention is not limited to this example. Thus, the separator-attached sealing sheet may be a case where a separator is stacked on/over only one surface of a sealing sheet, i.e., a single-sided separator-attached sealing sheet.
In the present embodiment, the separator-attached sealing sheet will be described. However, the present invention may be a single member of a sealing sheet, on/over which no separator is stacked. The sealing sheet, on/over which no separator is stacked, may be, for example, in the form that the separator 41a and the separator 41b are not stacked in the separator-attached sealing sheet 10 (a single member of the sealing sheet 40).

(Sealing Sheet)

About the sealing sheet 40, the product of the thickness t [mm] thereof and the storage modulus G' [Pa] thereof at 50°C satisfies an expression 1 described below.

$$\text{Expression 1: } 300 \leq \alpha \leq 1.5 \times 10^5$$

The lower limit of the product $\alpha$ is preferably 400, more preferably 500. The upper limit of the product $\alpha$ is 1.4 $\times 10^5$, more preferably 1.3 $\times 10^5$. The product $\alpha$ is in the range satisfying the expression 1; thus, the sealing sheet can be restrained from dropping down from an adsorbing collet when the collet-held sheet is, for example, carried, and further one or more semiconductor chips can be suitably buried into the sealing sheet.

The thickness t of the sealing sheet 40 is from 0.05 to 1.3 mm both inclusive, preferably from 0.1 to 1.0 mm both inclusive. By setting the thickness t to 0.05 mm or more, one or more semiconductor chips can be suitably buried into the sheet. In the meantime, by setting the thickness t to 1.3 mm or less, the thickness of the semiconductor device to be produced can be made small.

The thickness of any sealing sheet denotes a value obtained by measuring 25 sites of the sheet at random, and then averaging the measured values.

The storage modulus G' of the sealing sheet 40 is from 400 to 180000 Pa both inclusive, preferably from 600 to 170000 Pa both inclusive. By setting the storage modulus G' to 400 Pa or more, flow of the resin is restrained, so that the thickness of the semiconductor device is satisfactorily controllable at the time of burying the semiconductor chip (s). In the meantime, by setting the storage modulus G' to 180000 Pa or less, the semiconductor chip(s) can be satisfactorily buried into the sheet.

The storage modulus G' of any sealing sheet denotes the storage modulus thereof after the raw material of the sealing sheet is shaped into the sealing sheet, and before this material is thermally set. The method for measuring the storage modulus G' is according to a method described in EXAMPLES. The storage modulus G' [Pa] is controllable by varying the composition constituting the sealing sheet 40 through, e.g., a change of an inorganic filler in amount filled into the composition, or in particle diameter.

About the sealing sheet 40, the product $\gamma$ of the thickness t [mm] thereof before the sheet is thermally set, and the storage modulus E' [Pa] thereof at 25°C after the thermal setting is preferably 1200000 or more, more preferably 1500000 or more. About the thickness of a sealing sheet, the sheet is weaker against impact from the outside as the thickness is smaller. In the meantime, the sheet is stronger against impact from the outside as the thickness is larger. About the storage modulus of a sealing sheet after the sheet is thermally set, the sheet is softer to be weaker against impact from the outside as the value of the modulus is smaller. In the meantime, the sheet is harder to be stronger against impact from the outside as the value is larger. Accordingly, when the thickness of a sealing sheet is smaller, the sheet can suitably protect one or more semiconductor chips from, e.g., impact from the outside even when the sheet is small, to some degree, in storage modulus after thermally set. In the meantime, when the thickness of the sealing sheet is smaller, the sheet cannot suitably protect the semiconductor chip(s) from, e.g., impact from the outside unless the storage modulus after the thermal setting is increased to some degree. The inventors have found out that the thickness of a sealing sheet and the storage modulus thereof after the sheet is thermally set are closely related to the semiconductor-chip-protecting performance of the sheet after the chip(s) are sealed. The inventors also found out that when the above-mentioned product $\gamma$ is set to 1200000 or more, the sealing sheet 40 has a good hardness after thermally set so that the sheet can suitably protect one or more semiconductor chips from, e.g., impact from the outside.

According to these facts, when the product $\gamma$ is set to 1200000 or more, the sealing sheet 40 can suitably protect one or more semiconductor chips from, e.g. , impact from the outside.

The area A of the sealing sheet 40 when viewed in plan is preferably 40000 mm$^2$ or more. The area A is more preferably 70650 mm$^2$ or more, even more preferably 90000 mm$^2$ or more. The sealing sheet 40 is restrained from bending since the sheet satisfies the expression 1. Accordingly, even when the area A of the sealing sheet 40 is rendered a large area of 40000 mm$^2$ or more, this sheet can be restrained from dropping down from an adsorbing collet when the collet-held sheet is, for example, carried. The sealing sheet 40 is also excellent since the usability of the sheet with a large area improves the production efficiency thereof. Moreover, as the area A is larger, a more preferable result is produced. However, the area is, for example, preferably 562500 mm$^2$ or less, more preferably 500000 mm$^2$ or less to make it possible that the sealing sheet does not easily drop down from an adsorbing collet when the collet-held sheet is, for example, carried.

The shape of the sealing sheet 40 when viewed in plan is not particularly limited, and may be a rectangular or circular shape. The shape is in particular preferably a rectangular shape having each side having a length of from 200 to 750 mm both inclusive. For reference, when all the sides are each 200 mm in length, the area A is 40000 mm$^2$. When all the sides are each 750 mm in length, the area A is 562500 mm$^2$.

(Sealing Sheet)

The constituent material of the sealing sheet 40 contains an epoxy resin, and a phenolic resin as a curing agent. Thereby, the sheet 10 can gain a good thermosetting property.

The epoxy resin is not especially limited. For example, various kinds of epoxy resins can be used such as a triphenylmethane-type epoxy resin, a cresol novolac-type epoxy resin, a biphenyl-type epoxy resin, a modified bisphenol A-type epoxy resin, a bisphenol A-type epoxy resin, a bisphenol F-type epoxy resin, a modified bisphenol F-type epoxy resin, a dicyclopentadiene-type epoxy resin, a phenol novolac-type epoxy resin, and a phenoxy resin. These epoxy resins may be used alone or in combination of two or more thereof.

From the viewpoint of securing the toughness of the epoxy resin after curing and the reactivity of the epoxy resin, epoxy resins are preferable which are solid at normal temperature and have an epoxy equivalent of 150 to 200 and a softening point or melting point of 50 to 130°C. Among these epoxy resins, a triphenylmethane-type epoxy resin, a cresol novolac-type epoxy resin, and a biphenyl-type epoxy resin are more preferable from the viewpoint of reliability.

The phenol resin is not especially limited as long as it initiates curing reaction with the epoxy resin. For example, there can be used a phenol novolac resin, a phenolaralkyl resin, a biphenylaralkyl resin, a dicyclopentadiene-type phenol resin, a cresol novolac resin, a resol resin, etc. These phenol resins may be used alone or in combination of two or more thereof.

From the viewpoint of the reactivity with the epoxy resin, phenol resins are preferably used which have a hydroxy group equivalent of 70 to 250 and a softening point of 50 to 110°C. Among these phenol resins, a phenol novolac resin is more preferably used from the viewpoint of its high curing reactivity. Further, phenol resins having low moisture absorbability can be also preferably used such as a phenolaralkyl resin and a bisphenylaralkyl resin from the viewpoint of reliability.

For the compounding ratio of the phenol resin to the epoxy resin, the epoxy resin and the phenol resin are preferably compounded so that the total amount of the hydroxy group in the phenol resin is 0.7 to 1.5 equivalents, and more preferably 0.9 to 1.2 equivalents, to 1 equivalent of the epoxy group in the epoxy resin.

The total content of the epoxy resin and the phenol resin in the sealing sheet 40 is preferably 2.5% by weight or more, and more preferably 3.0% by weight or more. If the content is 2.5% by weight or more, good adhering strength to the semiconductor chips 23 and the semiconductor wafer 22 can be obtained. The total content of the epoxy resin and the phenol resin in the sealing sheet 40 is preferably 20% by weight or less, and more preferably 10% by weight or less. If the content is 20% by weight or less, moisture absorbability can be decreased.

The sealing sheet 40 may contain a thermoplastic resin. This makes it possible to provide a handling property when the sealing sheet 40 is uncured and low stress property to the cured product.

Examples of the thermoplastic resin include natural rubber, butyl rubber, isoprene rubber, chloroprene rubber, an ethylene-vinylacetate copolymer, an ethylene-acrylic acid copolymer, an ethylene-acrylate copolymer, a polybutadiene resin, a polycarbonate resin, a thermoplastic polyimide resin, polyamide resins such as 6-nylon and 6,6-nylon, a phenoxy resin, an acrylic resin, saturated polyester resins such as PET and PBT, a polyamideimide resin, a fluororesin, and a styrene-isobutylene-styrene block copolymer. These thermoplastic resins may be used alone or in combination of two or more thereof. Among these, a styrene-isobutylene-styrene block copolymer is preferable from the viewpoint of its low stress property and low moisture absorption.

The content of the thermoplastic resin in the sealing sheet 40 may be 1.5% by weight or more, or 2.0% by weight or more. If the content is 1.5% by weight or more, the flexibility can be obtained. The content of the thermoplastic resin in the sealing sheet 40 is preferably 6% by weight or less, and more preferably 4% by weight or less. If the content is 4% by weight or less, the adhesion with the semiconductor chips 23 and the semiconductor wafer 22 is good.

The sealing sheet 40 preferably contains an inorganic filler.

The inorganic filler is not especially limited, and various kinds of conventionally known fillers can be used. Examples thereof include powers of quartz glass, talc, silica (such as fused silica and crystalline silica), alumina, aluminum nitride, silicon nitride, and boron nitride. These may be used alone or in combination of two or more kinds. Among these, silica and alumina are preferable, and silica is more preferable due to the reason that the linear expansion coefficient can be satisfactorily decreased.

As silica, silica powers are preferable, and fused silica powers are more preferable. Examples of the fused silica powders include spherical fused silica powders and crushed and fused silica powders. However, spherical fused silica powders are preferable from the viewpoint of fluidity. Among these, powers having an average particle size of 10 to 30 μm are preferable, and powders having an average particle size of 15 to 25 μm are more preferable.

The average particle size can be obtained, for example, by measurement on a sample that is extracted arbitrarily from the population using a laser diffraction-scattering type particle size distribution measuring apparatus. Among these, silica powders are preferable having an average particle size of 10 μm to 30 μm, and more preferable having an average particle size of 15 μm to 25 μm.

For example, the average particle size can be measured by using a laser diffraction-scattering type particle size distribution measuring apparatus on a sample that is arbitrarily extracted from the population.

The content of the inorganic filler in the sealing sheet 40 is preferably 75% by weight to 95% by weight, and more preferably 78% by weight to 95% by weight relative to the total content of the sealing sheet 40. If the content of the inorganic filler is 75% by weight or more relative to the total content of the sealing sheet 40, the thermal expansion coefficient can be kept low, and thus mechanical damage due to thermal impact can be suppressed. On the other hand, if the content of the inorganic filler is 95% by weight or less relative to the total content of the sealing sheet 40, the flexibility, the fluidity, and the adhesion become more satisfactory.

The sealing sheet 40 preferably contains a curing accelerator.

The curing accelerator is not especially limited as long as it promotes curing of the epoxy resin and the phenol resin, and examples of the curing accelerator include organophosphate compounds such as triphenylphosphine and tetraphenylphosphonium tetraphenylborate; and imidazole compounds such as 2-phenyl-4,5-dihydroxymethylimidazole and 2-phenyl-4-methyl-5-hydroxymethylimidazole. Among these, 2-phenyl-4,5-dihydroxymethylimidazole is preferable due to the reason that the curing reaction does not rapidly proceed even when the temperature increases during kneading and the sealing sheet 40 can be produced satisfactorily.

The content of the curing accelerator is preferably 0.1 to 5 parts by weight to the total 100 parts by weight of the epoxy resin and the phenol resin.

The sealing sheet 40 preferably contains a flame retardant component. This makes it possible to reduce an expansion of combustion when the sealing sheet 40 catches fire due to short circuit of the parts or heat generation. Examples of the flame retardant component include various kinds of metal hydroxides such as aluminum hydroxide, magnesium hydroxide, iron hydroxide, calcium hydroxide, tin hydroxide, and composite metal hydroxide; and a phosphazene flame retardant.

From the viewpoint of exhibiting flame retardancy even with a small amount, the content of phosphorus element in the phosphazene flame retardant is preferably 12% by weight or more.

The content of the flame retardant component in the sealing sheet 40 is preferably 10% by weight or more, and more preferably 15% by weight or more in the entire organic component (excluding inorganic filler) . If the content is 10% by weight or more, the flame retardancy can be obtained satisfactorily. The content of the thermoplastic resin in the sealing sheet 40 is preferably 30% by weight or less, and more preferably 25% by weight or less. If the content is 30% by weight or less, deterioration in the physical properties (deterioration in physical properties such as glass transition temperature and resin strength at high temperature) of the cured product tends to be suppressed.

The sealing sheet 40 preferably contains a silane coupling agent. The silane coupling agent is not especially limited, and an example includes 3-glycidoxypropyl trimethoxysilane.

The content of the silane coupling agent in the sealing sheet 40 is preferably 0.1 to 3% by weight. If the content is 0.1% by weight or more, the strength of the cured product is sufficiently made high, so that the water absorption can be lowered. If the content is 3% by weight or less, the amount of outgas can be decreased.

The sealing sheet 40 is preferably colored. With this configuration, The sealing sheet 40 can exhibit an excellent marking property and an excellent appearance, and a semiconductor device can be obtained having an appearance with added value. Because the colored sealing sheet 40 has an excellent marking property, various information such as character information and pattern information can be given by marking. Especially, the information such as character information and pattern information that is given by marking can be recognized visually with excellent visibility by controlling the color. It is possible to color-code the sealing sheet 40 by product, for example. When the sealing sheet 40 is colored (when it is not colorless or transparent), the color is not especially limited. However, the color is preferably a dark color such as black, blue, or red, and black is especially preferable.

When the sealing sheet 40 is colored, a coloring material (colorant) is usable in accordance with a target color. Various dark color materials such as black color materials, blue color materials, and red color materials can be suitably used, and especially the black color materials are suitable. The color materials may be any of pigments, dyes, and the like. The color materials can be used alone or two types or more can be used together. Any dyes such as acid dyes, reactive dyes, direct dyes, dispersive dyes, and cationic dyes can be used. The pigments are also not especially limited in the form, and may be appropriately selected from known pigments.

Besides the above-mentioned individual components, any other additive may be appropriately blended into the sealing sheet 40, as required.

The method of manufacturing the sealing sheet 40 is not especially limited; however, preferred examples are a method of preparing a kneaded product of the resin composition for forming the sealing sheet 40 and applying the obtained kneaded product and a method of subjecting the obtained kneaded product to plastic-working to be formed into a sheet shape. This makes it possible to produce the sealing sheet 40 without using a solvent. Therefore, the effects on the semiconductor chip 23 from the volatilized solvent can be suppressed.

Specifically, each component described later is melted and kneaded with a known kneader such as a mixing roll, a pressure kneader, or an extruder to prepare a kneaded product, and the obtained kneaded product is applied or plastic-worked into a sheet shape. As a kneading condition, the temperature is preferably the softening point or higher of each component described above, and is for example 30 to 150°C. When the thermal curing property of the epoxy resin is considered, the temperature is preferably 40 to 140°C, and more preferably 60 to 120°C. The time is for example 1 to 30 minutes, and preferably 5 to 15 minutes.

The kneading is preferably performed under a reduced pressure condition (under reduced pressure atmosphere). This makes it possible to remove gas, and to prevent invasion of gas into the kneaded product. The pressure under the reduced pressure condition is preferably 0.1 kg/cm$^2$ or less, and more preferably 0.05 kg/cm$^2$ or less. The lower limit of the pressure under reduced pressure is not especially limited; however, it is 1 X 10$^{-4}$ kg/cm$^2$ or more.

When the kneaded product is applied to form the sealing sheet 40, the kneaded product after being melt-kneaded is preferably applied while it is at high temperature without being cooled. The application method is not especially limited, and examples thereof include bar coating, knife coating, and slot-die coating. The application temperature is preferably the softening point or higher of each component described above . When the thermal curing property and molding property of the epoxy resin are considered, the temperature is for example 40 to 150°C, preferably 50 to 140°C, and more preferably 70 to 120°C.

When forming the sealing sheet 40 by plastic-working the kneaded product, the kneaded product after melt-kneaded is preferably subjected to plastic-working while it is at high temperature without being cooled. The plastic-working process is not especially limited, and examples thereof include flat plate pressing, T-die extrusion, screw-die extrusion, rolling, roll kneading, inflation extrusion, coextrusion, and calendar molding. The temperature for plastic-working is preferably the softening point or higher of each component described above . When the thermal curing property and molding property of the epoxy resin are considered, the temperature is for example 40 to 150°C, preferably 50 to 140°C, and more preferably 70 to 120°C.

The resin, etc. for forming the sealing sheet 40 can be dissolved and dispersed into an appropriate solvent to prepare varnish, and the varnish can be applied to obtain the sealing sheet 40.

About the double-sided separator-attached sealing sheet 10, the product $\beta$ of the bend elastic constant E [N/mm$^2$] of the sheet 10 at 25°C and the area A [mm$^2$] of the sealing sheet 40 satisfies an expression 2 described below.

$$\text{Expression 2: } 4.0 \times 10^6 \leq \beta \leq 1.7 \times 10^9$$

The lower limit of the product $\beta$ is preferably $1.0 \times 10^7$, more preferably $5.0 \times 10^7$. The upper limit of the product $\beta$ is preferably $1.5 \times 10^9$, more preferably $1.0 \times 10^9$. When the product $\beta$ is in the range satisfying the expression 2, the double-sided separator-attached sealing sheet 10 is restrained from bending and the resin becomes good in burying ability into one or more semiconductor chips.

The bend elastic constant E of the double-sided separator-attached sealing sheet 10 at 25°C is from 100 to 3000 N/mm$^2$ both inclusive, preferably from 200 to 500 N/mm$^2$ both inclusive. By setting the bend elastic constant E to 100 N/mm$^2$ or more, flow of the resin is restrained, so that the thickness of the resultant semiconductor device is satisfactorily controllable when one or more semiconductor chips are buried into the sheet. In the meantime, by setting the bend elastic constant E to 3000 N/mm$^2$ or less, the semiconductor chip(s) can be satisfactorily buried into the sheet.

The bend elastic constant E of any sealing sheet denotes the bend elastic constant thereof after the raw material of the sealing sheet is shaped into the sealing sheet, and before this material is thermally set. The method for measuring the bend elastic constant is according to a method described in EXAMPLES . The bend elastic constant E [Pa] is controllable by varying the composition constituting the sealing sheet 40 through, e.g., a change of an inorganic filler in amount filled into the composition, or in particle diameter.

(Separator)

The separator 41a and the separator 41b are preferably selected to be integrated with the sealing sheet 40 to be the separator-attached sealing sheet 10 and cause the above-mentioned value $\beta$ to satisfy the expression 2. These separators are in particular preferably selected to be integrated with the sealing sheet 40 to be the separator-attached sealing sheet 10 and cause the bend elastic constant E at 25°C to be in the above-mentioned numerical value range.

In the present embodiment, the description has been made about a case where the separator-attached sealing sheet 10 of the present invention is a double-sided separator-attached sealing sheet. Thus, the description has been made under a condition that the "bend elastic constant E at 25°C of the separator-attached sealing sheet" of the present invention corresponds to the bend elastic constant at 25°C of the whole of the separator-attached sealing sheet 10, in which the separators 41a and 41b, and the sealing sheet 40 are integrated with each other. However, when the separator-attached sealing sheet of the present invention is a single-sided separator-attached sealing sheet, the "bend elastic constant E at 25°C of the separator-attached sealing sheet" of the present invention corresponds to the bend elastic constant at 25°C of the whole of the single-sided separator-attached sealing sheet, in which a sealing sheet is integrated with a separator stacked onto either surface of the sealing sheet.

An example of the separators 41a and 41b that can be appropriately used is a foliate body including a paper base such as paper; a fiber base such as cloth, unwoven fabric, felt, and a net; a metal base such as a metal foil and a metal plate; a plastic base such as a plastic sheet; a rubber base such as a rubber sheet; a foamed body such as a foamed sheet; and a laminate thereof (particularly, a laminate of a plastic base and other bases, a laminate of plastic sheets, etc.) In the present invention, a plastic base can be suitably used. Examples of a material of the plastic base include an olefin resin such as polyethylene (PE), polypropylene (PP), and an ethylene-propylene copolymer; a copolymer having ethylene as a monomer component such as an ethylene-vinylacetate copolymer (EVA), an ionomer resin, an ethylene-(meth)acrylate copolymer, and an ethylene-(meth)acrylate (random, alternate) copolymer; polyester such as polyethylene terephthalate (PET), polyethylene naphthalate (PEN), and polybutylene terephthalate (PBT); an acrylic resin; polyvinylchloride (PVC); polyurethane; polycarbonate; polyphenylenesulfide (PPS); an amide resin such as polyamide (nylon) and wholly aromatic polyamide (aramide); polyetheretherketone (PEEK); polyimide; polyetherimide; polyvinylidene chloride; ABS (an acrylonitrile-butadiene-styrene copolymer); a cellulose resin; a silicone resin; and a fluororesin. The separator 41a may be a single layer or a multiple layer having two or more layers. The separator 41a can be formed with a conventionally known method.

The separators 41a and 41b may be release-treated or may not be release-treated.

Examples of the releasing agent used in the release treatment include a fluorine-based releasing agent, a long chain alkylacrylate-based releasing agent, and a silicone-based releasing agent. Among these, a silicone-based releasing agent is preferable.

The thickness of the separators 41a and 41b are not particularly limited; however, it is preferably 50 $\mu$m or more, and more preferably 75 $\mu$m or more from a viewpoint of prevention of warping that is supposed to easily occur when the area of the sealing sheet 11 is large. From a viewpoint of ease of peeling of the separator, the thickness is preferably 300 $\mu$m or less, and more preferably 200 $\mu$m or less.

The thickness of the separator 41b is not particularly limited; however, it is preferably 10 $\mu$m or more, and more preferably 25 $\mu$m or more from a viewpoint of the handleability when peeling the separator. From a viewpoint of ease of peeling of the separator, the thickness is preferably 200 $\mu$m or less, and more preferably 100 $\mu$m or less.

Next, the method for manufacturing a semiconductor device using the sealing sheet 10 with separators on both surfaces will be explained.

(Production Method for Semiconductor Device)

Hereinafter, a description will be made about a production method according to the present invention for a semiconductor device with reference to Figs. 2 to 10. Figs. 2 to 10 are schematic sectional views for explaining the semiconductor device production method according to the invention. The description below is firstly about a production method for a semiconductor device designated the so-called fan-out wafer level package (WLP).

The production method for a semiconductor device according to the present invention includes at least the following:

step A of providing a stacked body including a temporary-fixation member and one or more semiconductor chips fixed onto the temporary-fixation member,

step B of providing a sealing sheet with a separator according to claim 1,

step C of arranging the sealing sheet with the separator over the semiconductor chip(s) of the stacked body, and

step D of burying the semiconductor chip(s) into the sealing sheet to form a sealed body in which the semiconductor chip(s) is/are buried in the sealing sheet.

[Stacked Body Providing Step]

As illustrated in Fig. 2, in the semiconductor device production method according to the present invention, a stacked body 50 is initially provided in which semiconductor chips 53 are temporarily fixed onto a temporary-fixation member 60 (step A). The stacked body 50 can be obtained, for example, through a temporary-fixation providing step and a semiconductor chip temporarily fixing step each detailed below.

<Tentatively Fixing Member Providing Step>

In a tentatively fixing member providing step, provided is a temporary-fixation member 60 in which a thermally expansive pressure-sensitive adhesive layer 60a is stacked on a supporting substrate 60b (see Fig. 2). Instead of the thermally expansive pressure-sensitive adhesive layer, a radiation curable pressure-sensitive adhesive layer is usable. In the present embodiment, a description is made about the temporary-fixation member 60 that is a member having a thermally expansive pressure-sensitive adhesive layer. However, the temporary-fixation member, in which the thermally expansible pressure-sensitive adhesive layer is laminated onto the supporting substrate, is described in detail in JP-A-2014-015490 and others; thus, the temporary-fixation member will be briefly described below.

(Thermally Expansive Pressure-Sensitive Adhesive Layer)

The thermally expansive pressure-sensitive adhesive layer 60a may be made of a pressure-sensitive adhesive composition containing a polymer component and a foaming agent. The polymer component (particularly as a base polymer) is preferably an acrylic polymer (which may be referred to as an "acrylic polymer A"). The acrylic polymer A may be a polymer made from a (meth)acrylate as a main monomer component. Examples of the (meth)acrylate include alkyl (meth)acrylates (for example, linear or branched alkyl esters in which the alkyl group has 1 to 30 carbon atoms, in particular, 4 to 18 carbon atoms, examples of these esters including methyl, ethyl, propyl, isopropyl, butyl, isobutyl, sec-butyl, t-butyl, pentyl, isopentyl, hexyl, heptyl, octyl, 2-ethylhexyl, isooctyl, nonyl, decyl, isodecyl, undecyl, dodecyl, tridecyl, tetradecyl, hexadecyl, octadecyl, and eicosyl esters); and cycloalkyl (meth)acrylates (for example, cyclopentyl and cyclohexyl esters). These (meth)acrylates may be used alone or in any combination of two or more thereof.

The acrylic polymer A may contain a unit corresponding to a different monomer component copolymerizable with the (meth) acrylate, as required, in order to be improved in cohesive strength, heat resistance, crosslinkability and others.

The weight-average molecular weight of the acrylic polymer A is not particularly limited, and is preferably from about 350000 to 1000000, more preferably from about 450000 to 800000.

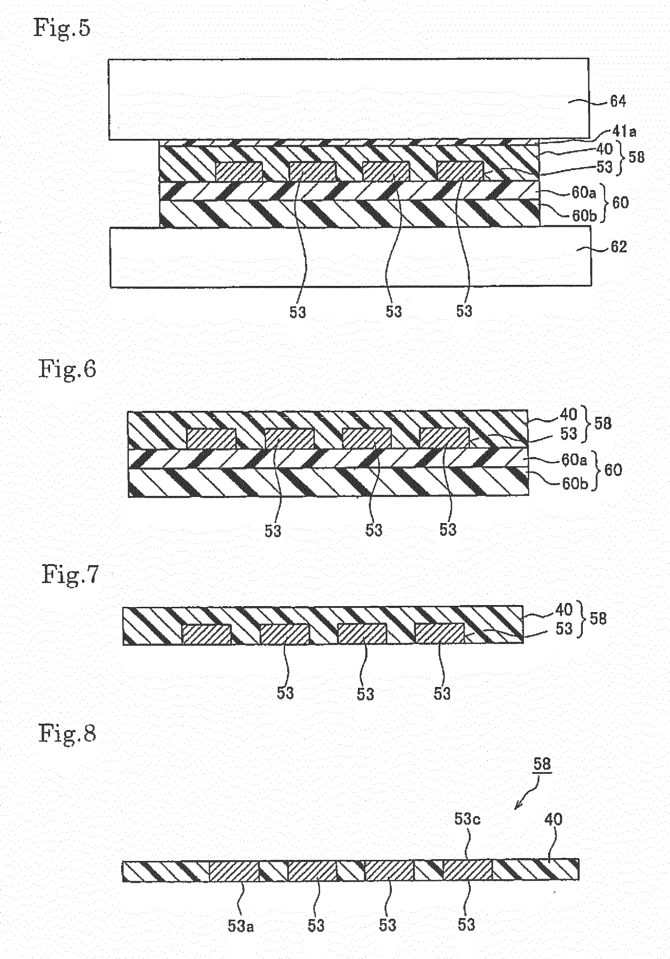

As described above, the thermally expansive pressure-sensitive adhesive layer 60a contains a foaming agent for giving thermal expansivity to this layer. Thus, in a state that a sealed body 58 is formed on the thermally expansive pressure-sensitive adhesive layer 60a of the temporary-fixation member 60 (see Fig. 6), at least a portion of the temporary-fixation member 60 is heated at any time to foam and/or expand the foaming agent contained in the heated portion of the thermally expansive pressure-sensitive adhesive layer 60a. Thus, at least the portion of the thermally expansive pressure-sensitive adhesive layer 60a expands. By the expansion of at least the portion of the thermally expansive pressure-sensitive adhesive layer 60a, the adhesive surface of this layer (the interface thereof with the sealed body 58), which corresponds to the expanding portion, is deformed into a bumpy form to decrease the area of the adhesive surface between the thermally expansive pressure-sensitive adhesive layer 60a and the sealed body 58. The decrease makes it possible to reduce the adhering strength between the two to peel the sealed body 58 from the temporary-fixation member 60 (see Fig. 7).

(Foaming Agent)

The foaming agent used in the thermally expansive pressure-sensitive adhesive layer 60a is not particularly limited, and is appropriately selectable from known foaming agents. About the foaming agent, a single species thereof or a combination of two or more species thereof may be used. The foaming agent is preferably thermally expansive microspheres.

(Thermally Expansive Microspheres)

The thermally expansive microspheres are not particularly limited, and are appropriately selectable from known thermally expansive microspheres (such as various inorganic thermally expansive microspheres and organic thermally expansive microspheres). The thermally expansive microspheres are preferably usable in the form of a micro-encapsulated foaming agent from the viewpoint of an easy blending operation thereof, and others. Such thermally expansive microspheres are, for example, microspheres obtained by encapsulating a substance which is heated to be easily gasified and expanded, such as isobutane, propane or pentane, into an elastic shell. In many cases, the shell is made of a thermally meltable substance or a substance which is thermally expansive to be broken. Examples of the substance that forms the shell include a vinylidene chloride-acrylonitrile copolymer, polyvinyl alcohol, polyvinyl butyral, polymethyl methacrylate, polyacrylonitrile, polyvinylidene chloride, and polysulfone.

The thickness of the thermally expansive pressure-sensitive adhesive layer is not particularly limited, and is appropriately selectable in accordance with the above-mentioned adhering-strength-lowering property of this layer, and others. The thickness is, for example, from about 5 to 300 $\mu$m (preferably from about 20 to 150 $\mu$m).

The thermally expansive pressure-sensitive adhesive layer may have a monolayered or multilayered structure.

In the present embodiment, the thermally expansive pressure-sensitive adhesive layer may contain various additives (such as a colorant, a thickener, an extender, a filler, a tackifier, a plasticizer, an antiaging agent, an antioxidant, a surfactant, and a crosslinking agent).

(Supporting Substrate)

The supporting substrate 60b is a thin plate-shaped member functioning as a strength base for the temporary-fixation member 60. The material of the supporting substrate 60b may be appropriately selected, considering the handleability and the heat resistance thereof, and others. Examples of the material include metal materials such as SUS; plastic materials such as polyimide, polyamideimide, polyetheretherketone, and polyethersulfone; glass; and a silicon wafer. A plate of SUS, out of these materials, is preferred from the viewpoint of the heat resistance, the strength, the reusability, and others.

The thickness of the supporting substrate 60b is appropriately selectable considering a target strength thereof and the handleability. The thickness is preferably from 100 to 5000 μm, more preferably from 300 to 2000 μm.

(Method for Forming Tentatively Fixing Member)

The temporary-fixation member 60 is obtained by forming the thermally expansive pressure-sensitive adhesive layer 60a onto the supporting substrate 60b. The thermally expansive pressure-sensitive adhesive layer can be formed by, for example, a conventional method of mixing a pressure-sensitive adhesive, a foaming agent (such as thermally expansive microspheres), and a solvent, other additives and so on that are optionally used, and then forming the mixture into a layer in a sheet form. Specifically, the thermally expansive pressure-sensitive adhesive layer can be formed by, for example, a method of applying, onto the supporting substrate 60b, a mixture containing a pressure-sensitive adhesive, a foaming agent (such as thermally expansive microspheres), and a solvent and other additives that are optionally used, or a method of applying the same mixture onto an appropriate separator (such as a release paper piece) to form a thermally expansive pressure-sensitive adhesive layer, and transferring (transcribing) this layer onto the supporting substrate 60b.

(Method for Thermally Expanding Thermally Expansive Pressure-Sensitive Adhesive Layer)

In the present embodiment, the thermally expansive pressure-sensitive adhesive layer can be thermally expanded by heating. The method for the heating can be performed using, for example, an appropriate heating means such as a hot plate, a hot air drier, a near infrared lamp or an air drier. In the heating, it is sufficient for the heating temperature to be not lower than the foaming starting temperature (thermal expansion starting temperature) of the foaming agent (such as the thermally expansive microspheres) in the thermally expansive pressure-sensitive adhesive layer. Conditions for the heating may be appropriately set in accordance with the reduction property of the adhesive surface area, the property being dependent on the kind of the foaming agent (such as the thermally expansive microspheres) and others, the heat resistance of the sealed body containing the supporting substrate and the semiconductor chips or of others, the heating method (the thermal capacity and the heating means, and others), and others. The heating conditions are generally as follows: a temperature of 100 to 250°C, and a period of 1 to 90 seconds (according to, for example, a hot plate), or a period of 5 to 15 minutes (according to, for example, a hot air drier) . The heating may be performed at an appropriate stage in accordance with a purpose of the use. As a heat source in the heating, an infrared lamp or heated water may be usable.

<Semiconductor Chip Temporarily Fixing Step>

In a semiconductor chip temporarily fixing step, plural semiconductor chips as the chips 53 are arranged and temporarily fixed onto the provided temporary-fixation member 60 to arrange their circuit-forming surfaces 53a to face the temporary-fixation member 60 (see Fig. 2). For the temporary fixation of the semiconductor chips 53, a known device, for example, a flip chip bonder and a die bonder, is usable.
The layout of the arrangement of the semiconductor chips 53, and the number of the chips arranged may be appropriately set in accordance with, for example, the shape and the size of the temporary-fixation member 60, and the number of target packages produced. The semiconductor chips 53 can be arranged into the form of a matrix in which plural rows and plural columns are lined up. When viewed in plan, the shape and the size of the stacked body 50 (the temporary-fixation member 60) are not particularly limited, and may be made identical with those of the above-mentioned separator-attached sealing sheet 10. The above has described an example of the stacked body providing step.

[Step of Providing Double-Sided Separator-Attached Sealing Sheet]

In the production method for a semiconductor device according to the present embodiment, a double-sided separator-attached sealing sheet 10 (see Fig. 1) according to claim 1 is provided (step B).

[Step Of Holding Up Double-Sided Separator-Attached Sealing Sheet]

After step B, as illustrated in Fig. 3, the double-sided separator-attached sealing sheet 10 is held up through the separator 41a by adsorbing collets 19. As well as the sealing sheet 11 and the separator 41b, the separator 41a of the double-sided separator-attached sealing sheet 10 and the sealing sheet 11 are bonded to each other at their surfaces by such a peel strength that the two members are not peeled off from each other by the weight of the two themselves.
In the present embodiment, about the sealing sheet 40, the product α of the thickness t [mm] and the storage modulus G' [Pa] thereof at 50°C satisfies the expression 1. It is therefore possible to restrain the following: the sealing sheet 40 bends to make a gap between any one of the adsorbing collets 19 and the double-sided separator-attached sealing sheet 10. As a result, the double-sided separator-attached sealing sheet 10 can be restrained from dropping down from the adsorbing collets 19.

[Step of Peeling Off Separators from Double-Sided Separator-Attached Sealing Sheet]

Next, the separator 41b is peeled off from the double-sided separator-attached sealing sheet 10. The separator 41a of the double-sided separator-attached sealing sheet 10, and the sealing sheet 40 are caused to adhere onto each other at their surfaces by such a peel strength that the two are not peeled off from each other when the separator 41b is peeled off.

[Step of Arranging Sealing Sheet and Stacked Body]

Next, as illustrated in Fig. 4, the stacked body 50 is arranged onto a lower heating plate 62 to direct the semiconductor-chip-53-temporarily-fixed surface of the stacked body 50 upward, and further the separator-41a-attached sealing sheet 40 is arranged onto the semiconductor-chip-53-temporarily-fixed surface of the stacked body 50 (step C). In this step, it is allowable to arrange the stacked body 50 initially onto the lower heating plate 62, and subsequently arrange the separator-41a-attached sealing sheet 40 onto the stacked body 50, or to stack the separator-41a-attached sealing sheet 40 first onto the stacked body 50, and subsequently arrange the resultant stacked body, in which the separator-41a-attached sealing sheet 40 is stacked on the stacked body 50, onto the lower heating plate 62.

[Step of Forming Sealed Body]

Next, as illustrated in Fig. 5, the lower heating plate 62 and an upper heating plate 64 are used to hot-press the workpiece to bury the semiconductor chips 53 into the sealing sheet 40 to form a sealed body 58 in which the semiconductor chips 53 are buried in the sealing sheet 40 (Step D). The sealing sheet 40 comes to function as a sealing resin for protecting the semiconductor chips 53 and elements accompanying the chips from the external environment. This process has given the sealed body 58, in which the semiconductor chips 53 fixed temporarily onto the temporary-fixation member 60 are buried in the sealing sheet 40.
Specifically, about conditions for the hot press when the semiconductor chips 53 are buried into the sealing sheet 40, the temperature is preferably from 40 to 150°C, more preferably from 60 to 120°C, the pressure is, for example, from 0.1 to 10 MPa, preferably from 0.5 to 8 MPa, and the period is, for example, from 0.3 to 10 minutes, preferably from 0.5 to 5 minutes. The method for the hot press may be parallel plate press, or roll press. Out of the two, parallel plate press is preferred.
In this way, a semiconductor device can be obtained in which the semiconductor chips 53 are buried in the sealing sheet 40. The press is performed preferably under reduced pressure conditions, considering the adhesiveness and the following-performance of the sealing sheet 40 to the semiconductor chips 53 and the temporary-fixation member 60.
About the reduced pressure conditions, the pressure is, for example, from 0.1 to 5 kPa, preferably from 0.1 to 100 Pa, and the reduced pressure holding period (period from the start of a reduction in the pressure to the start of the press) is, for example, from 5 to 600 seconds, preferably from 10 to 300 seconds.

[Step of Peeling Off the Other Separator]

Next, the other separator 41a is peeled off (see Fig. 6).

[Thermal Curing Step]

Next, the sealing sheet 40 is thermally cured. Specifically, for example, the whole of the sealed body 58 is heated, in which the semiconductor chips 53 fixed tentatively on the temporary-fixation member 60 are embedded in the sealing sheet 40.
About conditions for the thermal setting, the heating temperature is preferably 100°C or higher, preferably 120°C or higher. The upper limit of the heating temperature is preferably 200°C or lower, more preferably 180°C or lower. The heating period is preferably 10 minutes or longer, more preferably 30 minutes or longer. The upper limit of the heating period is preferably 180 minutes or shorter, more preferably 120 minutes or shorter. As needed, the setting may be attained under an increased pressure. The pressure is preferably 0.1 MPa or more, more preferably 0.5 MPa or more. The upper limit thereof is preferably 10 MPa or less, more preferably 5 MPa or less.

[Step of Peeling Thermally Expansive Pressure-Sensitive Adhesive Layer]

Next, as illustrated in Fig. 7, the temporary-fixation member 60 is heated to thermally expand the thermally expansive pressure-sensitive adhesive layer 60a to peel the thermally expansive pressure-sensitive adhesive layer 60a and the sealed body 58 from each other. Alternatively, the following method is also preferably adoptable : a method of peeling the supporting substrate 60b and the thermally expansive pressure-sensitive adhesive layer 60a from each other at the interface therebetween, and then peeling the thermally expansive pressure-sensitive adhesive layer 60a and the sealed body 58 from each other at the interface therebetween by thermal expansion. In any one of these cases, the thermally expansive pressure-sensitive adhesive layer 60a is heated to be thermally expanded, thereby being lowered in adhesive strength to make it possible to peel the thermally expansive pressure-sensitive adhesive layer 60a and the sealed body 58 easily from each other at the interface therebetween. It is preferred to adopt, as conditions for the thermal expansion, the conditions in the above-mentioned column "Method for Thermally Expanding Thermally Expansive Pressure-Sensitive Adhesive Layer." The thermally expansive pressure-sensitive adhesive layer is in particular preferably formed to have a structure permitting this layer not to be peeled by the heating in the above-mentioned thermal curing step but to be peeled by the heating in this step of peeling the thermally expansive pressure-sensitive adhesive layer.

[Step of Grinding Sheet for Sealing]

Next, as illustrated in Fig. 8, the sealing sheet 40 in the sealed body 58 is ground to expose the respective rear surfaces 53c of the semiconductor chips 53, as required. The method for grinding the sealing sheet 40 is not particularly limited, and may be, for example, a grinding method using a grinding stone rotatable at a high velocity.

(Re-Interconnect Forming Step)

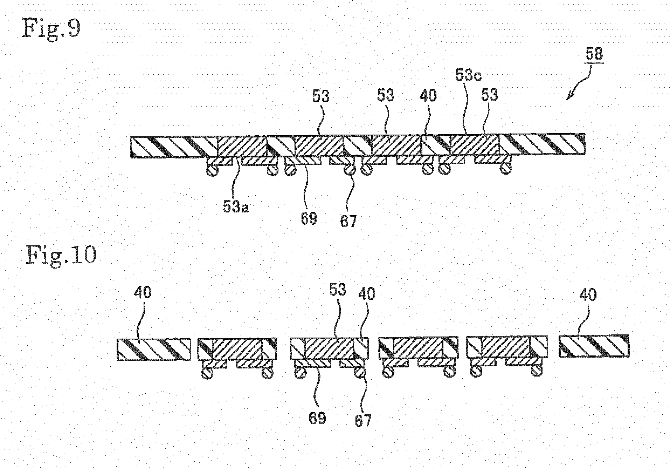

The present embodiment preferably includes a re-interconnect forming step of forming re-interconnects 69 on the circuit-forming surfaces 53a of the semiconductor chips 53 of the sealed body 58. In the re-interconnect forming step, after the peeling of the temporary-fixation member 60, the re-interconnects 69, which are connected to the exposed semiconductor chips 53, are formed on the sealed body 58 (see Fig. 9).
In a method for forming the re-interconnects, for example, a known method such as a vacuum-deposition method is used to form a metal seed layer onto the exposed semiconductor chips 53, and then the re-interconnects 69 can be formed by a known method such as a semi-additive method.
Thereafter, an insulating layer of, for example, polyimide or PBO may be formed on the re-interconnects 69 and the sealed body 58.

(Bump Forming Step)

Next, a bumping processing may be performed in which bumps 67 are formed on the formed re-interconnects 69 (see Fig. 9) . The bumping processing may be performed by a known method using, for example, solder balls or solder plating.

(Dicing Step)

Lastly, the stacked body, which is composed of the semiconductor chips 53, the sealing sheet 40, the re-interconnects 69, and the other elements, is diced (see Fig. 10). This step can give the semiconductor devices 59 in the state that the interconnects are led to the outside of the chip regions.
In the above-mentioned embodiment, the description has been made about a case where the "stacked body" in the present invention is the "stacked body 50, in which the semiconductor chips 53 are temporarily fixed onto the temporary-fixation member 60". However, the "stacked body" in the present invention is not limited to this example. It is sufficient for the stacked body to be a stacked body in which one or more semiconductor chips are fixed on to a support having a certain measure of strength. In other words, it is sufficient for the "stacked body" to be a "stacked body in which one or more semiconductor chips are fixed onto a support". Other examples of the "stacked body" in the invention include a "stacked body in which one or more semiconductor chips are flip-chip-bonded to a circuit-forming surface of a semiconductor wafer" (the so-called chip-on-wafer) and a "stacked body in which one or more semiconductor chips are mounted on an organic substrate" .
Hereinafter, the present invention will be described in detail by way of examples thereof. In each of the examples, the word "part(s)" denotes part(s) by weight unless otherwise specified.
Components used in the working examples are described.
Epoxy resin: YSLV-80XY, manufactured by Nippon Steel Chemical Corp. (bisphenol F type epoxy resin; epoxy equivalent: 200 g/eq., and softening point: 80°C)
Phenolic resin: MEH-7851-SS, manufactured by Meiwa Plastic Industries, Ltd. (phenolic resin having a biphenylaralkyl skeleton; hydroxyl equivalent: 203 g/eq., and softening point: 67°C)
Silane coupling agent: KBM-403, manufactured by Shin-Etsu Chemical Co., Ltd. (3-glycidoxypropyltrimethoxysilane)
Setting promoter: 2PHZ-PW, manufactured by Shikoku Chemicals Corp. (2-phenyl-4,5-dihydroxymethylimidazole)
Thermoplastic resin: J-5800, manufactured by Mitsubishi Rayon Co., Ltd. (acrylic rubbery stress relaxation agent)
Filler: FB-9454FC, manufactured by Denka Co., Ltd. (spherical fused silica powder; average particle diameter: 17.6 $\mu$m)
Carbon black: #20, manufactured by Mitsubishi Chemical Corp. (particle diameter: 50 nm)

[Production of Sealing Sheets]

(Examples 1 to 12, and Comparative Examples 1 to 8)

Kneaded products (resin compositions A to E) according to Production Examples 1 to 5, respectively, were produced by blending individual components with each other in accordance with a blend ratio shown in Table 1, and then using a roll kneader to melt and knead the blend at 60 to 120°C for 10 minutes under a reduced pressure condition (0.01 kg/cm$^2$).
Next, the resultant resin compositions were each made into a sheet form by a flat plate pressing method. In each of the captioned examples, a combination of the kinds of the resin composition with the thickness and the area of the sheet was set as shown in Table 2. In this way, respective sealing sheets of Examples 1 to 12 and Comparative Examples 1 to 8 were yielded. In the present examples, the area of 250000 mm$^2$ was 500 mm in length $\times$ 500 mm in width, and the area of 40000 mm$^2$ was 200 mm in length $\times$ 200 mm in width.

[Production of Double-Sided Separator-Attached Sealing Sheets]

Silicone-release-treated products MRU-50 (corresponding to separators in the present invention; thickness: 50 $\mu$m) manufactured by Mitsubishi Plastics Inc. were bonded, respectively, to both surfaces of each of the sealing sheets produced as described. In this way, double-sided separator-attached sealing sheets according to Examples 1 to 12 and Comparative Examples 1 to 8, respectively, were yielded.

[Table 1]

| | | Production Examples | | | | |
|---|---|---|---|---|---|---|
| | | 1 | 2 | 3 | 4 | 5 |
| Resin composition | | A | B | C | D | E |
| Blend ratio (parts by weight) in kneaded product | Epoxy resin | 100 | 100 | 100 | 100 | 100 |
| | Phenolic resin | 45 | 105 | 55 | 120 | 120 |
| | Silane coupling agent | 1.5 | 0 | 0.2 | 1.35 | 2.2 |
| | Carbon black | 3.3 | 6.6 | 0.6 | 1.8 | 2.8 |
| | Setting promoter | 1.5 | 2 | 2.3 | 3.3 | 3.3 |
| | Thermoplastic resin | 0 | 50 | 0 | 0 | 55 |
| | Filler | 1470 | 1940 | 470 | 680 | 1130 |

[Measurement of Storage Modulus G' of Each of Sealing Sheets at 50°C]

A viscoelascity measuring instrument ARES (manufactured by Rheometric Scientific Inc.) was used to measure the storage modulus G' of the sealing sheet of each of Examples 1 to 12, and Comparative Examples 1 to 8 at 50°C. Conditions for the measurement were set as described below. The value at 50°C at this time was defined as the storage modulus G' of the sheet at 50°C. The results are shown in Table 2. In the measurement, the sealing sheet was a sealing sheet which had the same composition as each of Examples 1 to 12 and Comparative Examples 1 to 8 and had a thickness of 1 mm, and which was produced by flat plate pressing. After the production, the sheet was worked into a shape having a diameter of 25 mm, and the resultant was measured.

<Conditions for Measuring Storage Modulus G'>

Measuring temperature: 40 to 130°C
Temperature-raising rate: 10°C/min.
Plate type: parallel plate having a diameter of 25 mm
Frequency: 1 Hz
Strain quantity: 10%
Sample size: 25 mm in diameter × 1 mm in thickness

[Measurement of Bend Elastic Constant E of Each of Separator-Attached Sealing Sheets at 25°C]

A measuring autograph (manufactured by Shimadzu Corp.) was used to measure the bend elastic constant E of the separator-attached sealing sheet of each of Examples 1 to 12 and Comparative Examples 1 to 8 at 25°C. Conditions for the measurement were set as described below. The results are shown in Table 2. The measurement was made in the state that the separators adhered, respectively, onto both the surfaces of the sealing sheet.

<Conditions for Measuring Bend Elastic Constant E>

Measuring temperature: 25°C
Sample size: 10 mm in width × 5 mm in thickness
Stroke: 5 mm/min.

[Measurement of Storage Modulus E' of Each of Sealing Sheets at 25°C after Thermal Setting]

The sealing sheet of each of the working examples and the comparative examples was heated at 150°C for 1 hour to be thermally set. Next, a film viscoelasticity measuring instrument RSA-3 (manufactured by TA Instruments Inc.) was used to measure the storage modulus E' of the sealing sheet of each of Examples 1 to 12, and Comparative Examples 1 to 8 at 25°C after the thermal setting. Conditions for the measurement were set as described below. The results are shown in Table 2.

<Conditions for Measuring Storage Modulus E'>

Measuring temperature: -20 to 300°C
Temperature-raising rate: 10°C/min.
Measuring mode: tensile
Frequency: 1 Hz
Strain quantity: 0.05%
Sample size: 20 mm in length × 1 mm in width × 0.05 mm in thickness

[Evaluation of Handleability]

The double-sided separator-attached sealing sheet of each of Examples 1 to 12 and Comparative Examples 1 to 8 was held up through one of its release-treated films by an adsorbing collet. When the other release-treated film was peeled off, it was checked whether or not the sealing sheet dropped down. When the sealing sheet did not drop down and the resin was neither deformed nor broken with the naked eye, the sheet was judged to be O. Alternatively, when the sealing sheet dropped down or it was found out that the resin was deformed, broken or cracked, the sheet was judged to be ×. The results are shown in Table 2.
The used adsorbing collet was a collet described below. Conditions for the adsorbing were set as described below.

<Adsorbing Conditions>

Adsorbing pads: 8 pads each having a diameter of 30 mm
Vacuum degree: -60 kPa.

[Evaluation of Burying ability]

Initially, a glass plate, 200 mm in length × 200 mm in width × 1.1 mm in thickness, was prepared. A temporary-fixation member (REVALPHA No. 3195V) manufactured by Nitto Denko Corp. was bonded onto this glass plate with a laminator. Furthermore, chips each of 7 mm in length $\times$ 7 mm in width $\times$ 0.4 mm in thickness were arranged thereonto in the form of a matrix of 13 rows and 13 columns. The chip mounting interval thereof (interval between edges of any adjacent two of the chips) was set to 16 mm. Each of the sealing sheets, which had been beforehand made into the form of a sheet having a thickness of 0.6 mm, was laminated onto this glass carrier, and the resultant was hot-pressed, using a vacuum press machine (machine name : VACUUM ACE, manufactured by Mikado Technos Co., Ltd.). Next, on a hot plate of 60°C, the sealing sheet was trimmed to remove unnecessary regions of the resin. Thereafter, the workpiece was heated at 150°C for 1 hour to set the resin. Thereafter, the temporary-fixation member was peeled off from the workpiece on a hot plate of 185°C to yield a sealed body.

A microscope (device name: VHX-2000, manufactured by Keyence Corp.) was used to observe a boundary region between the chips on the chip-naked surface of the resultant sealed body, and the resin thereof. When a resin-unfilled region or an air-taken-in scar was observed in the edge of any one of the chips, the sealing sheet was judged to be $\times$ in burying ability. Alternatively, when the region or the scar was not observed, the sealing sheet was judged to be O in burying ability. The results are shown in Table 2.

[Table 2]

| | Example 1 | Example 2 | Example 3 | Example 4 | Example 5 | Example 6 | Example 7 | Example 8 | Example 9 | Example 10 | Example 11 | Example 12 |
|---|---|---|---|---|---|---|---|---|---|---|---|---|
| Resin composition | A | B | C | A | B | C | A | B | C | A | B | C |
| Thickness t [mm] of sealing sheet | 0.8 | | | 0.1 | | | 0.8 | | | 0.1 | | |
| Area A [mm²] | 250000 | | | 250000 | | | 40000 | | | 40000 | | |
| G' [Pa] | 150,000 | 90,000 | 1,000 | 150,000 | 90,000 | 3,000 | 150,000 | 90,000 | 1,000 | 150,000 | 90,000 | 3,000 |
| E [N/mm²] | 2500 | 1000 | 100 | 2500 | 1000 | 100 | 2500 | 1000 | 100 | 2500 | 1000 | 100 |
| α | 120,000 | 72,000 | 800 | 15,000 | 9,000 | 300 | 120,000 | 72,000 | 800 | 15,000 | 9,000 | 300 |
| β | $6.25 \times 10^8$ | $2.5 \times 10^8$ | $2.5 \times 10^7$ | $6.25 \times 10^7$ | $2.5 \times 10^8$ | $2.5 \times 10^7$ | $1 \times 10^8$ | $4 \times 10^7$ | $4 \times 10^6$ | $1 \times 10^8$ | $4 \times 10^7$ | $4 \times 10^6$ |
| E' [Pa] | $1.7 \times 10^{10}$ | $1.3 \times 10^{10}$ | $9.4 \times 10^9$ | $1.7 \times 10^9$ | $1.3 \times 10^{10}$ | $9.4 \times 10^9$ | $1.7 \times 10^{10}$ | $1.3 \times 10^{10}$ | $9.4 \times 10^9$ | $1.7 \times 10^{10}$ | $1.3 \times 10^{10}$ | $9.4 \times 10^9$ |
| Handleability | O | O | O | O | O | O | O | O | O | O | O | O |
| Burying ability | O | O | O | O | O | O | O | O | O | O | O | O |

| | Comparative Example 1 | Comparative Example 2 | Comparative Example 3 | Comparative Example 4 | Comparative Example 5 | Comparative Example 6 | Comparative Example 7 | Comparative Example 8 |
|---|---|---|---|---|---|---|---|---|
| Resin composition | D | E | D | E | D | E | D | E |
| Thickness t [mm] of sealing sheet | 0.8 | | 0.1 | | 0.8 | | 0.1 | |
| Area A [mm²] | 250000 | | 250000 | | 40000 | | 40000 | |
| G' [Pa] | 100 | 300 | 100 | 300 | 100 | 300 | 100 | 300 |
| E [N/mm²] | 300 | 3 | 300 | 3 | 300 | 3 | 300 | 3 |
| α | 80 | 240 | 10 | 30 | 80 | 240 | 10 | 30 |
| β | $7.5 \times 10^7$ | $7.5 \times 10^5$ | $7.5 \times 10^7$ | $7.5 \times 10^5$ | $1.2 \times 10^7$ | $1.2 \times 10^5$ | $1.2 \times 10^7$ | $1.2 \times 10^5$ |
| E' [Pa] | $1.3 \times 10^7$ | $2.3 \times 10^{10}$ | $1.3 \times 10^7$ | $2.3 \times 10^{10}$ | $1.3 \times 10^7$ | $2.3 \times 10^{10}$ | $1.3 \times 10^7$ | $2.3 \times 10^{10}$ |
| Handleability | × | × | × | × | × | × | × | × |
| Burying | O | × | O | × | O | × | O | × |

DESCRIPTION OF REFERENCE SIGNS

| 10: | Double-sided separator-attached sealing sheet |
|---|---|
| 40: | Sealing sheet |

41a, 41b:  Separator
50:  Stacked body
53:  Semiconductor chip
58:  Sealed body
59:  Semiconductor device
60:  Temporary-fixation member

**Claims**

1.  A sealing sheet with a separator comprising:

    a sealing sheet, and
    a separator which is stacked over at least one surface of the sealing sheet,
    wherein said sealing sheet has a thickness t of 0.05 to 1.3 mm and a storage modulus G' at 50°C of 400 to 180000 Pa, wherein the product $\alpha$ of t in mm and G' in Pa satisfies the following expression 1:

$$\text{expression 1: } 300 \leq \alpha \leq 1.5 \times 10^5,$$

    and wherein the constituent material of said sealing sheet contains an epoxy resin, and a phenolic resin as a curing agent, and
    wherein the sealing sheet with the separator has a bend elastic constant E at 25°C of 100 to 3000 N/mm$^2$ and an area A of 40000 mm$^2$ or more; wherein the product $\beta$ of E in N/mm$^2$ and A in mm$^2$ satisfies the following expression 2:

$$\text{expression 2: } 4.0 \times 10^6 \leq \beta \leq 1.7 \times 10^9.$$

2.  A production method for a semiconductor device, comprising:

    step A of providing a stacked body comprising a support (60) and one or more semiconductor chips (53) fixed onto the support,
    step B of providing the sealing sheet with the separator (10) that is recited in claim 1,
    step C of arranging the sealing sheet with the separator over the semiconductor chip(s) of the stacked body, and
    step D of burying the semiconductor chip(s) into the sealing sheet to form a sealed body in which the semiconductor chip(s) is/are buried in the sealing sheet.

3.  The production method of claim 2, further comprising a step E of peeling off the separator.

4.  The production method of claim 3, further comprising a step F of thermally curing the sealing sheet.

**Patentansprüche**

1.  Dichtungsbahn mit einem Trennelement, umfassend:

    eine Dichtungsbahn, und
    ein Trennelement, das mindestens über eine Oberfläche der Dichtungsbahn gestapelt ist,
    wobei die Dichtungsbahn eine Dicke von 0,05 bis 1,3 mm und einen Speichermodul G' bei 50 °C von 400 bis 180000 Pa aufweist, wobei das Produkt $\alpha$ aus t in mm und G' in Pa dem nachstehenden Ausdruck 1 genügt:

$$\text{Ausdruck 1: } 300 \leq \alpha \leq 1,5 \times 10^5,$$

    und wobei das Aufbaumaterial der Dichtungsbahn ein Epoxidharz, und ein Phenolharz als ein Härtungsmittel enthält, und

wobei die Dichtungsbahn mit dem Trennelement eine Biegeelastizitätskonstante E bei 25 °C von 100 bis 3000 N/mm$^2$ und eine Fläche A von 40000 mm$^2$ oder mehr aufweist; wobei das Produkt β aus E in N/mm$^2$ und A in mm$^2$ dem nachstehenden Ausdruck 2 genügt:

$$\text{Ausdruck 2: } 4,0 \times 10^6 \leq \beta \leq 1,7 \times 10^9.$$

2. Herstellungsverfahren für eine Halbleitervorrichtung, umfassend:

einen Schritt A des Bereitstellens eines gestapelten Körpers, der einen Träger (60) und einen oder mehrere auf dem Träger befestigte Halbleiterchip(s) (53) umfasst,
einen Schritt B des Bereitstellens der Dichtungsbahn mit dem Trennelement (10), das in Anspruch 1 zitiert wird,
einen Schritt C des Anordnens der Dichtungsbahn mit dem Trennelement über dem/den Halbleiterchip(s) des gestapelten Körpers, und
einen Schritt D des Versenkens der Halbleiterchip(s) in die Dichtungsbahn, um einen abgedichteten Körper zu bilden, in dem der/die Halbleiterchip(s) in der Dichtungsbahn eingebettet ist/sind.

3. Herstellungsverfahren nach Anspruch 2, das des Weiteren einen Schritt E des Ablösens des Trennelements umfasst.

4. Herstellungsverfahren nach Anspruch 3, das des Weiteren einen Schritt F des thermischen Aushärtens der Dichtungsbahn umfasst.

**Revendications**

1. Feuille d'étanchéité ayant un séparateur comprenant :

une feuille d'étanchéité, et
un séparateur qui est empilé sur au moins une surface de la feuille de d'étanchéité,
dans laquelle ladite feuille d'étanchéité a une épaisseur t de 0,05 à 1,3 mm et un module de conservation G' à 50°C de 400 à 180 000 Pa, dans laquelle le produit α de t en mm et de G' en Pa satisfait à l'expression 1 suivante :

$$\text{expression 1 : } 300 \leq \alpha \leq 1,5 \times 10^5,$$

et dans laquelle le matériau constitutif de ladite feuille d'étanchéité contient une résine époxy, et une résine phénolique en tant qu'agent de durcissement, et
dans laquelle la feuille d'étanchéité avec le séparateur a une constante élastique de pliage E à 25°C de 100 à 3 000 N/mm$^2$ et une surface A de 40 000 mm$^2$ ou plus ; dans laquelle le produit β de E en N/mm$^2$ et de A en mm$^2$ satisfait à l'expression 2 suivante :

$$\text{expression 2 : } 4,0 \times 10^6 \leq \beta \leq 1,7 \times 10^9.$$

2. Procédé de production d'un dispositif à semi-conducteur, comprenant :

une étape A de fourniture d'un corps empilé comprenant un support (60) et une ou plusieurs puces à semi-conducteur (53) fixées sur le support,
une étape B de fourniture de la feuille d'étanchéité ayant le séparateur (10) selon la revendication 1,
une étape C de disposition de la feuille d'étanchéité ayant le séparateur sur la ou les puces à semi-conducteur du corps empilé, et
une étape D d'enfouissement de la ou des puces à semi-conducteur dans la feuille d'étanchéité pour former un corps étanchéifié dans lequel la ou les puces à semi-conducteur est/sont enterrée(s) dans la feuille d'étanchéité.

3. Procédé de production selon la revendication 2, comprenant en outre une étape E de pelage du séparateur.

4. Procédé de production selon la revendication 3, comprenant en outre une étape F de durcissement thermique de la feuille d'étanchéité.

Fig.1

41a  ⎫
40   ⎬ 10
41b  ⎭

Fig.2

50

53    53    53    53

53a

60a ⎫
    ⎬ 60
60b ⎭

Fig.3

19                    19

41a ⎫
40  ⎬ 10
41b ⎭

Fig.4

64

41a
40

50

60a ⎫
    ⎬ 60
60b ⎭

62

53    53    53

Fig.5

Fig.6

Fig.7

Fig.8

Fig.9

Fig.10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006019714 A
- US 2007254986 A

- US 2012295416 A
- JP 2014015490 A